# EUROPEAN PATENT APPLICATION

(11) **EP 4 582 288 A1**
(43) Date of publication of application: **09.07.2025**
(21) Application number: 24223127.2
(22) Date of filing: 23.12.2024
(51) Int. Cl.: B60L 3/04, H02H 1/00, H02H 3/05, H02H 3/087, H02H 7/18

(54) **DUAL OUTPUT CURRENT SENSOR, SYSTEM FOR PROVIDING SHORT CIRCUIT PROTECTION HAVING A DUAL OUTPUT CURRENT SENSOR, AND ASSOCIATED METHOD**

(30) Priority: 05.01.2024 CN 202410021372
(71) Applicant: Honeywell International Inc., Charlotte, NC 28202 (US)
(72) Inventor: YANG, Fan, Charlotte, 28202 (US); HAN, Liansheng, Charlotte, 28202 (US); HU, Yu, Charlotte, 28202 (US); SONG, Ting, Charlotte, 28202 (US); LIU, Zhi, Charlotte, 28202 (US); GE, Jun, Charlotte, 28202 (US)
(74) Representative: Haseltine Lake Kempner LLP

(57) **Abstract**

A dual-output current sensor (300) is provided. For example, a dual-output current sensor may include a current sensing element (305) to detect a current, a current comparison circuity (315) to determine if the detected current exceeds a predetermined threshold current, a first output channel (325) to output an indication of the detected current from the current sensor, a drive circuit (320) to produce an amplified output of the current comparison circuity, and a second output channel (330) to output the amplified output of the current comparison circuity from the current sensor.

Fig. 3

## Description

### FIELD OF THE INVENTION

Embodiments of the present disclosure generally relate to sensing devices, and, more particularly, to current sensors.

### BACKGROUND

Short circuit protection systems are important in electrical systems. For example, such short circuit protection systems are used in electric vehicles to protect the motor and battery from short circuits which can expose sensitive components to very high currents.

Such short circuit protection systems are plagued by technical challenges and limitations. Through applied effort, ingenuity, and innovation, many of these identified problems have been solved by developing solutions that are included in embodiments of the present disclosure, many examples of which are described in detail herein.

### BRIEF SUMMARY

Various embodiments described herein relate to dual output current sensors, systems for providing short circuit protection in electric vehicles, and associated methods of providing short circuit protection.

In accordance with various embodiments of the present disclosure, a system for providing short circuit protection is provided. In some embodiments, the system comprises a dual-output current sensor. The dual-output current sensor comprises a current sensing element to detect a current, a current comparison circuity to determine if the detected current exceeds a predetermined threshold current, a first output channel to output an indication of the detected current from the current sensor, a drive circuit to produce an amplified output of the current comparison circuity, and a second output channel to output the amplified output of the current comparison circuity from the current sensor.

In some embodiments, the current sensing element outputs a voltage that is proportional to the detected current, and the current comparison circuity comprises an analog voltage comparison circuitry that compares the voltage that is proportional to the detected current to a reference voltage that corresponds to the predetermined threshold current.

In some embodiments, the current sensing element outputs a voltage that is proportional to the detected current, the current comparison circuity comprises an analog to digital controller (ADC) and a controller, the ADC receives the voltage that is proportional to the detected current and converts the voltage that is proportional to the detected current to a digital value of the detected current, and the controller receives the digital value of the detected current and compares the digital value of the detected current to the predetermined threshold current.

In some embodiments, the system further comprises a battery management system, an electric busbar carrying the detected current, and a normally closed pyrotechnic switch connected inline with the electric busbar. The first output channel outputs the indication of the detected current to a battery management system of an electric vehicle, and the second output channel outputs the amplified output of the current comparison circuity to a pyrotechnic switch to cause the pyrotechnic switch to open and interrupt the detected current on the electric busbar.

In some embodiments, if the detected current exceeds the predetermined threshold current, the current sensor receives a command from the battery management system to actuate the pyrotechnic switch and the second output channel outputs the amplified output of the current comparison circuity to the pyrotechnic switch in response to the current sensor receiving the command from the battery management system to actuate the pyrotechnic switch.

In accordance with various embodiments of the present disclosure, a system for providing short circuit protection in an electric vehicle is provided. In some embodiments, the system comprises a battery management system, an electric busbar, a normally closed pyrotechnic switch connected inline with the electric busbar, and a dual-output current sensor to detect a current on the electric busbar. The current sensor comprises a current sensing element to detect the current on the electric busbar, a current comparison circuity to determine if the detected current exceeds a predetermined threshold current, a first output channel to output an indication of the detected current from the current sensor to the battery management system, a drive circuit to produce an amplified output of the current comparison circuity, and a second output channel to output the amplified output of the current comparison circuity from the current sensor to the pyrotechnic switch to cause the pyrotechnic switch to open and interrupt the current on the electric busbar.

In accordance with various embodiments of the present disclosure, a method of providing short circuit protection in an electric vehicle is provided. In some embodiments, the method comprises connecting a dual-output current sensor to an electric busbar of the electric vehicle; detecting, by a current sensing element of the current sensor, the current on the electric busbar; determining, by a current comparison circuitry of the current sensor, if the detected current exceeds a predetermined threshold current; outputting, by a first output channel of the current sensor to a battery management system of the electric vehicle, an indication of the detected current; producing, by a drive circuit of the current sensor, an amplified output of the current comparison circuity; and outputting, by a second output channel of the current sensor to a pyrotechnic switch of the electric vehicle, the amplified output of the current comparison circuity to cause the pyrotechnic switch to open and interrupt the current on the electric busbar.

The foregoing illustrative summary, as well as other exemplary objectives and/or advantages of the disclosure, and the manner in which the same are accomplished, are further explained in the following detailed description and its accompanying drawings.

### BRIEF DESCRIPTION OF THE DRAWINGS

The description of the illustrative embodiments may be read in conjunction with the accompanying figures. It will be appreciated that, for simplicity and clarity of illustration, elements illustrated in the figures have not necessarily been drawn to scale, unless described otherwise. For example, the dimensions of some of the elements may be exaggerated relative to other elements, unless described otherwise. Embodiments incorporating teachings of the present disclosure are shown and described with respect to the figures presented herein, in which:
FIG. 1 is a block diagram of an example system for providing short circuit protection, in accordance with example embodiments of the present disclosure;
FIG. 2 is a block diagram of an example dual output current sensor that may be used in the system of FIG. 1, in accordance with example embodiments of the present disclosure;
FIG. 3 is a block diagram of an example dual output current sensor that may be used in the example system of FIG. 1, in accordance with alternative example embodiments of the present disclosure;
FIG. 4 is a circuit diagram of an example drive circuit that may be used in the example dual output current sensor of FIG. 2 or the example dual output current sensor of FIG. 3;
FIG. 5 is a circuit diagram of an example comparison circuit that may be used in the example dual output current sensor of FIG. 3; and
FIG. 6 is flowchart illustrating an example method of providing short circuit protection, in accordance with example embodiments of the present disclosure.

### DETAILED DESCRIPTION OF THE INVENTION

Some embodiments of the present disclosure will now be described more fully hereinafter with reference to the accompanying drawings, in which some, but not all embodiments of the disclosure are shown. Indeed, these disclosures may be embodied in many different forms and should not be construed as limited to the embodiments set forth herein; rather, these embodiments are provided so that this disclosure will satisfy applicable legal requirements. Like numbers refer to like elements throughout.

As used herein, terms such as "front," "rear," "top," "bottom," "left," "right," etc. are used for explanatory purposes in the examples provided below to describe the relative position of certain components or portions of components. Furthermore, as would be evident to one of ordinary skill in the art in light of the present disclosure, the terms "substantially" and "approximately" indicate that the referenced element or associated description is accurate to within applicable engineering tolerances.

As used herein, the term "comprising" means including but not limited to and should be interpreted in the manner it is typically used in the patent context. Use of broader terms such as comprises, includes, and having should be understood to provide support for narrower terms such as consisting of, consisting essentially of, and comprised substantially of.

The phrases "in one embodiment," "according to one embodiment," "in some embodiments," and the like generally mean that the particular feature, structure, or characteristic following the phrase may be included in at least one embodiment of the present disclosure and may be included in more than one embodiment of the present disclosure (importantly, such phrases do not necessarily refer to the same embodiment).

The phrases "in one example," "according to one example," "in some examples," and the like generally mean that the particular feature, structure, or characteristic following the phrase may be included in at least one example of the present disclosure and may be included in more than one example of the present disclosure (importantly, such phrases do not necessarily refer to the same example).

If the specification states a component or feature "may," "can," "could," "should," "would," "preferably," "possibly," "typically," "optionally," "for example," "as an example," "in some examples," "often," or "might" (or other such language) be included or have a characteristic, that specific component or feature is not required to be included or to have the characteristic. Such component or feature may be optionally included in some examples, or it may be excluded.

The word "example" or "exemplary" is used herein to mean "serving as an example, instance, or illustration." Any implementation described herein as "example" or "exemplary" is not necessarily to be construed as preferred or advantageous over other implementations.

The term "electronically coupled," "electronically coupling," "electronically couple," "in communication with," "in electronic communication with," or "connected" in the present disclosure refers to two or more elements or components being connected through wired means and/or wireless means, such that signals, electrical voltage/current, data and/or information may be transmitted to and/or received from these elements or components.

The term "component" may refer to an article, a device, or an apparatus that may comprise one or more surfaces, portions, layers and/or elements. For example, an example component may comprise one or more substrates that may provide underlying layer(s) for the component and may comprise one or more elements that may form part of and/or are disposed on top of the substrate. In the present disclosure, the term "element" may refer to an article, a device, or an apparatus that may provide one or more functionalities.

The term "sensor" or "sensing device" may refer to an article, a device, or an apparatus that measures physical input from its environment and converts the input into data that can be interpreted by either a human or a machine. Sensing devices may be utilized in a variety of applications including measuring electric current.

The term "sensing element," "sensor circuitry," "sensing circuitry," and the like may refer to one or more components, integrated circuits, and the like within a sensing device that interacts with the environment, detects the input to be detected (e.g., electric current), and provides an output (e.g., voltage) to another component in the sensing device to be interpreted. In an example electric current sensing device, the sensing circuitry may comprise an open-loop Hall-effect sensor, a closed-loop Hall-effect sensor, a fluxgate sensor, or any suitable sensing element.

Providing short circuit protection in electrical devices is important, and especially so in electric vehicles where a short circuit can result in electric currents in excess of 2000 amperes (amps or "A"). Such high currents can quickly damage sensitive electric and electronic components. Fuses are often used for short circuit protection, but fuses may take one to two seconds to break the circuit which may be too slow to provide the desired protection. These fuses are often termed passive fuses. Pyrotechnic fuses are explosive switches that can break the circuit more quickly than passive fuses, but typically require a very large current (e.g., 4000 amps or more) to actuate and break the circuit.

To address challenges and limitations associated with conventional short circuit protection, various examples of the present disclosure may be provided. For example, various examples of the present disclosure may provide example dual output current sensors, systems for short circuit protection, and methods for short circuit protection.

In various embodiments, an example dual output current sensor provides current monitoring to detect a short circuit and provides two outputs as described herein. While embodiments of the present disclosure are described herein in relation to electric vehicles, embodiments of the present disclosure may be used with any electric device in which rapid short circuit protection is desired.

In various embodiments, an example dual output current sensor is connected to a busbar of an electric vehicle to measure the primary current on the busbar. In various embodiments, a first output of an example dual output current sensor provides an indication of the measured primary current to a battery management system (BMS) of an electric vehicle. In various embodiments, a second output of an example dual output current sensor provides a control signal to a pyrotechnic switch of an electric vehicle when the measured primary current exceeds a predetermined threshold.

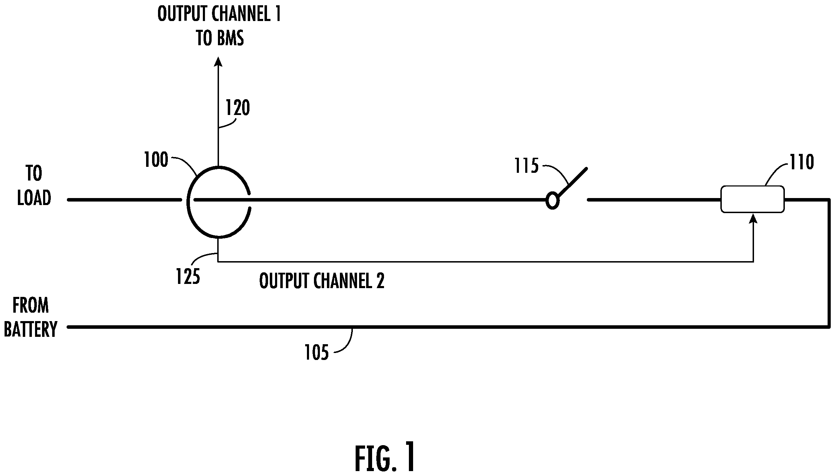

Referring now to FIG. 1, a block diagram of an example system for providing short circuit protection in accordance with various embodiments of the present disclosure is provided. As depicted in FIG. 1, in various embodiments such a system comprises an electric busbar 105 for carrying electric current from a battery (which may be, for example, one large battery pack or multiple batteries connected together) of an electric vehicle to one or more load components (e.g., drive motors), a pyrotechnic switch 110 connected inline with the busbar 105, a relay 115 connected inline with the busbar 105 for selectively enabling or disabling current flow to the load components, and a dual output current sensor 100 positioned to measure the primary current flowing through the busbar 105. In various embodiments, the current sensor 100 is configured to execute and perform the operations described herein. The relay 115 is one example component that would likely be damaged (e.g., fused closed) by a high current short circuit.

In some embodiments, the current sensor 100 defines a substantially circular through-hole and the current sensor 100 is positioned such that a portion of the busbar 105 protrudes through the through-hole in the current sensor 100 to enable the current sensor 100 to detect and measure the current flowing through the busbar 105.

In various embodiments, the pyrotechnic switch 110 is normally closed and would explosively open within microseconds when subjected to a very high current short circuit (e.g., greater than 4000 amps). However, it is desirable to have similarly fast short circuit protection with short circuits causing currents that are high enough to damage components but not high enough to directly trigger the pyrotechnic switch 110. Thus, the current sensor of various embodiments of the disclosure provides a control signal to actuate (i.e., open) the pyrotechnic switch when the measured primary current exceeds a threshold that is predetermined to be high enough to damage components but not high enough to directly trigger the pyrotechnic switch.

In various embodiments as illustrated in FIG. 1, the current sensor 100 has two outputs: a first output 120 that provides an indication of the measured primary current to a battery management system (BMS) of an electric vehicle and a second output 125 that provides a control signal to the pyrotechnic switch 110 to cause the pyrotechnic switch 110 to actuate (i.e., open) when the measured primary current exceeds the predetermined threshold. In one exemplary embodiment, the threshold current is 2000 amps, but any suitable threshold current may be used.

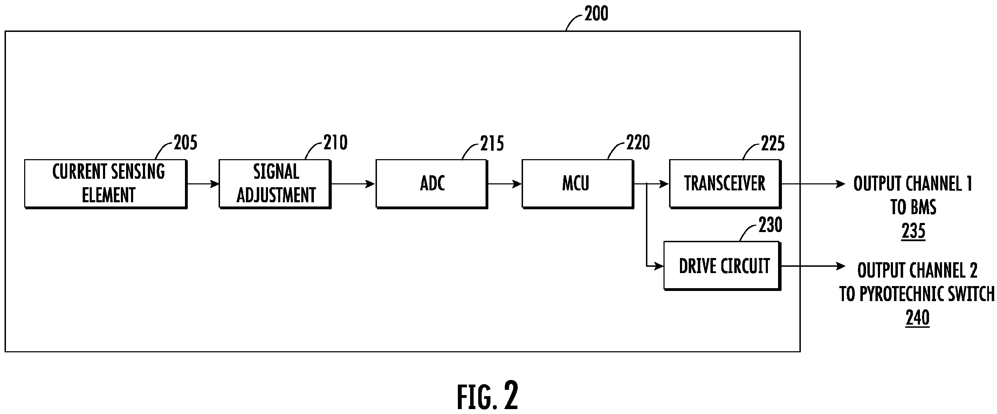

In various embodiments, the current sensor may have a digital version and an analog version. Referring now to FIG. 2, block diagram of a digital version of an example dual output current sensor is illustrated in accordance with example embodiments of the present disclosure. As depicted in FIG. 2, a dual output current sensor 200 comprises a current sensing element 205, a signal adjustment element 210, an analog to digital controller (ADC) 215, a processing element (such as a microcontroller unit) (MCU) 220, a transceiver 225, and a drive circuit 230. The current sensor 200 has two outputs: a first output channel 235 that provides an indication of the measured primary current to a BMS of an electric vehicle and a second output channel 240 that provides a control signal to a pyrotechnic switch to cause the pyrotechnic switch to actuate (i.e., open) when the measured primary current exceeds the predetermined threshold.

In various embodiments, the sensing element 205 may comprise a magnetic field current sensor magnetically coupled to a conductor (i.e., a busbar) and configured to generate a magnetic field signal having a magnitude responsive to a current flowing through the conductor. In various alternative embodiments, the sensing element 205 may comprise a shunt interface having first and second input terminals electrically coupled to ends of a shunt disposed along a conductor (i.e., busbar) and configured to generate a shunt signal having a magnitude responsive to the current flowing through the conductor. In various embodiments, the sensing element 205 may comprise an open-loop Hall-effect sensor, a closed-loop Hall-effect sensor, a fluxgate sensor, or any suitable current sensing element.

In various embodiments, the sensing element 205 produces an analog voltage that is proportional to the primary current flowing through the busbar. In various embodiments, the signal adjustment element 210 comprises an amplifier to amplify the voltage from the current sensing element 205. In some embodiments, the signal adjustment element is not needed.

In various embodiments, the ADC 215 converts the analog voltage from the current sensing element 205 (which may have been amplified by the signal adjustment element 210, if present) to a digital signal which is a representation of the measured current. In various embodiments, the MCU 220 receives the digital signal from the ADC 215 and compares the signal to the predetermined and stored threshold. In various embodiments, the MCU 220 sends the representation of the measured current to the transceiver 225, and the transceiver 225 outputs the representation of the measured current via the first output channel 235 to a BMS. In various embodiments of a digital version of an example dual output current sensor, the representation of the measured current is a digital output of the measurement.

In various embodiments, if the MCU 220 determines that the measured current exceeds the predetermined threshold, the MCU 220 outputs an overcurrent signal (e.g., a pulse width modulated (PWM signal) to the drive circuit 230. In various embodiments, the drive circuit 230 amplifies the overcurrent signal from the MCU 220 and outputs the amplified signal via the second output channel 240 to a pyrotechnic switch, thereby causing the pyrotechnic switch to actuate. In an example embodiment, the drive circuit functionality is provided by a Bosch CG912 four channel pyrotechnic fuse driver.

In various alternative embodiments, the decision to actuate the pyrotechnic switch is not made within the current sensor (such as within the MCU), but rather the decision to actuate the pyrotechnic switch is made within the BMS. In various alternative embodiments, if the BMS makes a decision to actuate the pyrotechnic switch, the BMS sends a control command to the current sensor, the control command is received by the current sensor via the transceiver 225, and a control signal is sent to the pyrotechnic switch from the current sensor via the second output channel 240. In various other alternative embodiments, if the BMS makes a decision to actuate the pyrotechnic switch, the BMS sends a control command directly to the pyrotechnic switch.

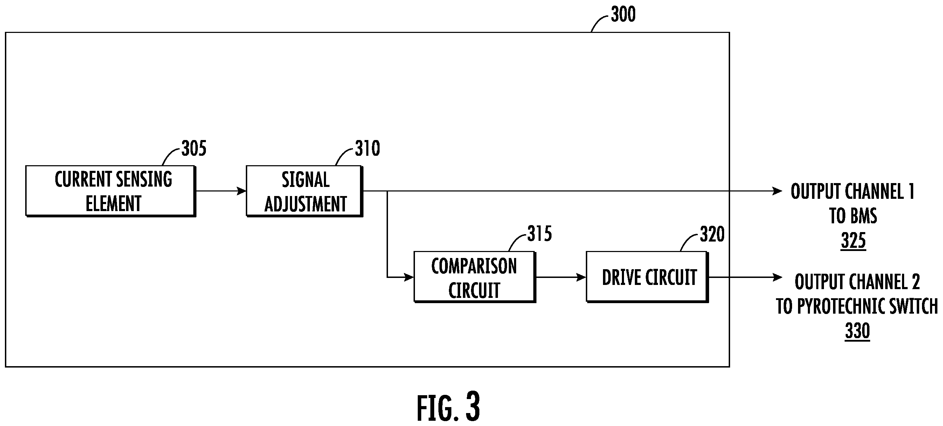

Referring now to FIG. 3, block diagram of an analog version of an example dual output current sensor is illustrated in accordance with example embodiments of the present disclosure. As depicted in FIG. 3, a dual output current sensor 300 comprises a current sensing element 305, a signal adjustment element 310, a comparison circuit 315, and a drive circuit 320. The current sensor 300 has two outputs: a first output channel 325 that provides an indication of the measured primary current to a BMS of an electric vehicle and a second output channel 330 that provides a control signal to a pyrotechnic switch to cause the pyrotechnic switch to actuate (i.e., open) when the measured primary current exceeds the predetermined threshold.

In various embodiments, the sensing element 305 may comprise an open-loop Hall-effect sensor, a closed-loop Hall-effect sensor, a fluxgate sensor, or any suitable current sensing element. In various embodiments, the sensing element 305 produces an analog voltage that is proportional to the primary current flowing through the busbar. In various embodiments, the signal adjustment element 310 comprises an amplifier to amplify the voltage from the current sensing element 305. In some embodiments, the signal adjustment element is not needed. In various embodiments, the analog voltage from the current sensing element 305 (which may have been amplified by the signal adjustment element 310, if present) is output via the first output channel 325 to a BMS. In various embodiments of an analog version of an example dual output current sensor, the representation of the measured current is proportional to the primary current.

In various embodiments, the analog voltage from the current sensing element 305 (which may have been amplified by the signal adjustment element 310, if present) is provided to the comparison circuit 315. In various embodiments, the comparison circuit 315 compares the analog voltage from the current sensing element 305 to a reference voltage that is selected to be equal to what the analog voltage from the current sensing element 305 will be if the primary current is equal to the threshold current. In various embodiments, if the analog voltage from the current sensing element 305 is higher than the reference voltage, the comparison circuit 315 will output a positive voltage to the drive circuit 320. In various embodiments, the drive circuit 320 amplifies the positive output voltage from the comparison circuit 315 and outputs the amplified signal via the second output channel 330 to a pyrotechnic switch, thereby causing the pyrotechnic switch to actuate.

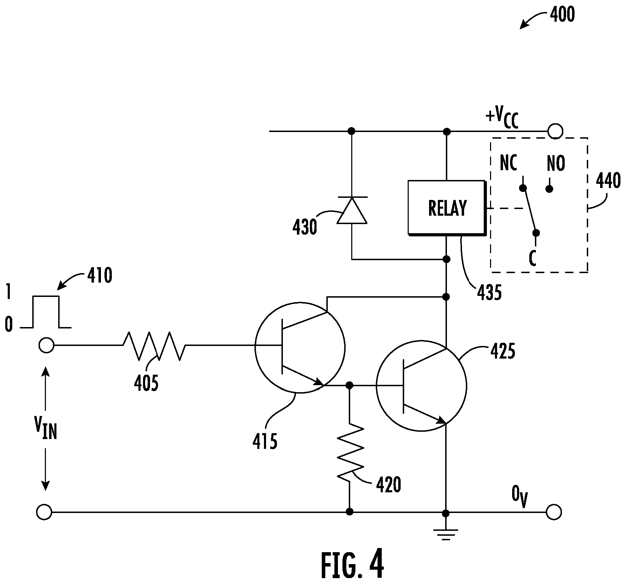

Dual output current sensors of embodiments of the present disclosure may use any suitable drive circuit that is capable of receiving a signal from an MCU (such as MCU 220) or a comparison circuit (such as comparison circuit 315) and amplifying the signal to the desired level needed to actuate a pyrotechnic switch. Referring now to FIG. 4, a circuit diagram of an example drive circuit that may be used in the example dual output current sensor of FIG. 2 or the example dual output current sensor of FIG. 3 is illustrated, in accordance with various embodiments of the disclosure. As seen in FIG. 4, the drive circuit 400 comprises a first resistor 405, a first transistor 415 (such as an NPN low power, silicon planar epitaxial transistor), a second resistor 420, a second transistor 425 (such as an NPN bipolar junction transistor), a diode 430, and a relay 435.

One end of the first resistor 405 is connected to an input of the drive circuit 400 to receive an input signal 410 (for example, from MCU 220 or comparison circuit 315) (which causes an input voltage (Vin)) and the other end is connected to the base of the first transistor 415. The emitter of the first transistor 415 is connected to one end of the second resistor 420 and to the base of the second transistor 425. The other end of the second resistor 420 and the emitter of the second transistor 425 are connected to ground. The collectors of the first transistor 415 and the second transistor 425 are connected to the anode of the diode 430 and to one end of the relay 435. The cathode of the diode 430 and the other end of the relay 435 are connected to the supply voltage (Vcc). The relay 435 is connected to and drives actuation of the pyrotechnic switch 440. In operation, when the drive circuit 400 receives a positive input signal 410 (for example, from MCU 220 or comparison circuit 315), which indicates an overcurrent has been detected, the input signal is amplified and actuates the relay 435 which actuates the pyrotechnic switch 440.

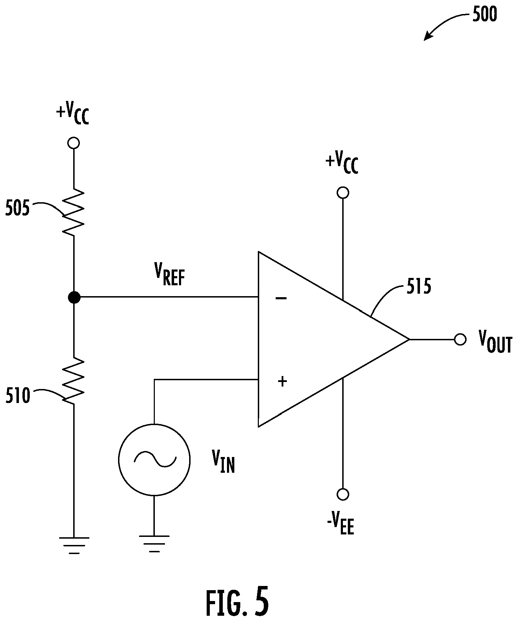

Dual output current sensors of embodiments of the present disclosure may use any suitable comparison circuit that is capable of receiving an analog voltage from a current sensing element (such as current sensing element 305), comparing that analog voltage to a reference voltage that is equal to what the analog voltage from the current sensing element will be if the primary current is equal to the threshold current, and, if the analog voltage from the current sensing element is higher than the reference voltage, outputting a positive voltage to a drive circuit (such as drive circuit 320). Referring now to FIG. 5 is a circuit diagram of an example comparison circuit that may be used in the example dual output current sensor of FIG. 3 is illustrated, in accordance with various embodiments of the disclosure. As seen in FIG. 5, the comparison circuit 500 comprises a first resistor 505 and a second resistor 510 connected in series between the supply voltage (Vcc) and ground and an op-amp 515. The negative input terminal of the op-amp 515 is connected between the first resistor 505 and the second resistor 510 and the positive input terminal of the op-amp 515 is connected to the analog voltage (Vin) from the current sensing element. The op-amp 515 is connected to a positive supply voltage (Vcc) and a negative supply voltage (V_{EE}). The output of the op-amp 515 is Vout. In various embodiments, the value the first resistor 505 and the value of the second resistor 510 are selected such that the reference voltage V_{REF} is equal to what the analog voltage from the current sensing element will be if the primary current is equal to the predetermined threshold current. In operation, when the analog voltage (Vin) from the current sensing element is greater than the predetermined threshold current, the output (Vout) of the op-amp 515 is positive. In various embodiments, this positive output is amplified by a drive circuit and actuates a pyrotechnic switch.

Although components are described with respect to functional limitations, it should be understood that at least some of the particular implementations necessarily include the use of particular computing hardware. It should also be understood that in some embodiments certain of the components described herein include similar or common hardware. For example, in some embodiments two sets of circuitry both leverage use of the same processor(s), memory(ies), circuitry(ies), and/or the like to perform their associated functions such that duplicate hardware is not required for each set of circuitry.

The MCU 220 may be embodied in a number of different ways. In various embodiments, the use of the terms "processor" or "processing circuitry" should be understood to include a single core processor, a multi-core processor, multiple processors internal to the current sensor 100, and/or one or more remote or "cloud" processor(s) external to the current sensor 100. In some example embodiments, MCU 220 may include one or more processing devices configured to perform independently. Alternatively, or additionally, MCU 220 may include one or more processor(s) configured in tandem via a bus to enable independent execution of operations, instructions, pipelining, and/or multithreading.

In an example embodiment, the MCU 220 may be configured to execute instructions stored in memory circuitry (not illustrated) or otherwise accessible to the processor. Alternatively, or additionally, the MCU 220 may be configured to execute hard-coded functionality. As such, whether configured by hardware or software methods, or by a combination thereof, MCU 220 may represent an entity (e.g., physically embodied in circuitry) capable of performing operations according to embodiments of the present disclosure while configured accordingly. Alternatively, or additionally, MCU 220 may be embodied as an executor of software instructions, and the instructions may specifically configure the MCU 220 to perform the various algorithms embodied in one or more operations described herein when such instructions are executed. In some embodiments, the MCU 220 includes hardware, software, firmware, and/or a combination thereof that performs one or more operations described herein.

In some embodiments, two or more of the sets of circuitries are combinable. Alternatively, or additionally, one or more of the sets of circuitry perform some or all of the operations and/or functionality described herein as being associated with another circuitry. In some embodiments, two or more of the sets of circuitry are combined into a single module embodied in hardware, software, firmware, and/or a combination thereof.

While the description above provides an example current sensor 100, it is noted that the scope of the present disclosure is not limited to the description above. In some examples, an example current sensor 100 in accordance with the present disclosure may be in other forms. In some examples, an example current sensor 100 may comprise one or more additional and/or alternative elements, and/or may be structured differently than that illustrated in FIGS. 2 and 3.

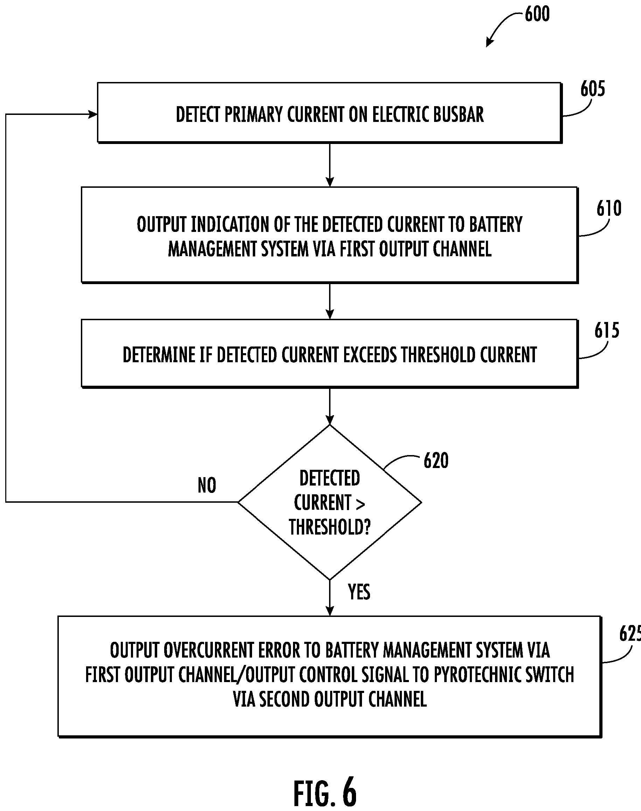

Reference will now be made to FIG. 6, which provides a flowchart illustrating example steps, processes, procedures, and/or operations in accordance with various embodiments of the present disclosure. Various methods described herein, including, for example, methods as shown in FIG. 6, may provide various technical benefits and improvements.

Referring now to FIG. 6, an example method 600 is illustrated. In some embodiments, the example method comprises a method for providing short circuit protection using a dual output current sensor. At step/operation 605, a dual output current sensor (such as, but not limited to, the dual output current sensor 200 described above in connection with FIG. 2 or the dual output current sensor 300 described above in connection with FIG. 3) detects a primary current on an electric busbar.

At step/operation 610, a dual output current sensor (such as, but not limited to, the dual output current sensor 200 described above in connection with FIG. 2 or the dual output current sensor 300 described above in connection with FIG. 3) outputs an indication of the detected current to a battery management system via a first output channel.

At step/operation 615, a dual output current sensor (such as, but not limited to, the dual output current sensor 200 described above in connection with FIG. 2 or the dual output current sensor 300 described above in connection with FIG. 3) determines if the detected current exceeds a predetermined threshold current.

If it is determined at step/operation 615 that the detected current does not exceed a predetermined threshold current, the method 600 returns to step/operation 605 and continues to monitor the primary current on the busbar. If it is determined at step/operation 615 that the detected current does exceed a predetermined threshold current, the method 600 proceeds to step/operation 625.

At step/operation 625, a dual output current sensor (such as, but not limited to, the dual output current sensor 200 described above in connection with FIG. 2 or the dual output current sensor 300 described above in connection with FIG. 3) outputs an overcurrent error to the battery management system via the first output channel and outputs a control signal to a pyrotechnic switch via a second output channel to actuate the pyrotechnic switch. In various alternative embodiments, the decision to actuate the pyrotechnic switch is made within the BMS and, if the BMS makes a decision to actuate the pyrotechnic switch, the BMS sends a control command to the current sensor and the current sensor receives the control command from the BMS (such as, but not limited to, via the transceiver 225 of the dual output current sensor 200 described above in connection with FIG. 2). This portion of step/operation 625 is in brackets to indicate that it is optional.

In some embodiments, the method 600 repeats steps/operations 605-620 until an overcurrent is detected and the pyrotechnic switch is actuated.

Operations and processes described herein support combinations of means for performing the specified functions and combinations of operations for performing the specified functions. It will be understood that one or more operations, and combinations of operations, may be implemented by special purpose hardware-based computer systems which perform the specified functions, or combinations of special purpose hardware and computer instructions.

In some example embodiments, certain ones of the operations herein may be modified or further amplified as described below. Moreover, in some embodiments additional optional operations may also be included. It should be appreciated that each of the modifications, optional additions or amplifications described herein may be included with the operations herein either alone or in combination with any others among the features described herein.

The foregoing method and process descriptions are provided merely as illustrative examples and are not intended to require or imply that the steps of the various embodiments must be performed in the order presented. As will be appreciated by one of skill in the art the order of steps in the foregoing embodiments may be performed in any order. Words such as "thereafter," "then," "next," and similar words are not intended to limit the order of the steps; these words are simply used to guide the reader through the description of the methods. Further, any reference to claim elements in the singular, for example, using the articles "a," "an" or "the," is not to be construed as limiting the element to the singular and may, in some instances, be construed in the plural.

While various embodiments in accordance with the principles disclosed herein have been shown and described above, modifications thereof may be made by one skilled in the art without departing from the teachings of the disclosure. The embodiments described herein are representative only and are not intended to be limiting. Many variations, combinations, and modifications are possible and are within the scope of the disclosure. Alternative embodiments that result from combining, integrating, and/or omitting features of the embodiment(s) are also within the scope of the disclosure. Accordingly, the scope of protection is not limited by the description set out above, but is defined by the claims which follow, that scope including all equivalents of the subject matter of the claims. Each and every claim is incorporated as further disclosure into the specification and the claims are embodiment(s) of the present disclosure. Furthermore, any advantages and features described above may relate to specific embodiments but shall not limit the application of such issued claims to processes and structures accomplishing any or all of the above advantages or having any or all of the above features.

In addition, the section headings used herein are provided for consistency with the suggestions under 37 C.F.R. § 1.77 or to otherwise provide organizational cues. These headings shall not limit or characterize the disclosure set out in any claims that may issue from this disclosure. For instance, a description of a technology in the "Background" is not to be construed as an admission that certain technology is prior art to any disclosure in this disclosure. Neither is the "Summary" to be considered as a limiting characterization of the disclosure set forth in issued claims. Furthermore, any reference in this disclosure to "disclosure" or "embodiment" in the singular should not be used to argue that there is only a single point of novelty in this disclosure. Multiple embodiments of the present disclosure may be set forth according to the limitations of the multiple claims issuing from this disclosure, and such claims accordingly define the disclosure, and their equivalents, which are protected thereby. In all instances, the scope of the claims shall be considered on their own merits in light of this disclosure but should not be constrained by the headings set forth herein.

Also, systems, subsystems, apparatuses, techniques, and methods described and illustrated in the various embodiments as discrete or separate may be combined or integrated with other systems, modules, techniques, or methods without departing from the scope of the present disclosure. Other devices or components shown or discussed as coupled to, or in communication with, each other may be indirectly coupled through some intermediate device or component, whether electrically, mechanically, or otherwise. Other examples of changes, substitutions, and alterations are ascertainable by one skilled in the art and could be made without departing from the scope disclosed herein.

Many modifications and other embodiments of the disclosure set forth herein will come to mind to one skilled in the art to which these embodiments pertain having the benefit of teachings presented in the foregoing descriptions and the associated figures. Although the figures only show certain components of the apparatuses and systems described herein, various other components may be used in conjunction with the components and structures disclosed herein. Therefore, it is to be understood that the disclosure is not to be limited to the specific embodiments disclosed and that modifications and other embodiments are intended to be included within the scope of the appended claims. For example, the various elements or components may be combined, rearranged, or integrated in another system or certain features may be omitted or not implemented. Moreover, the steps in any method described above may not necessarily occur in the order depicted in the accompanying drawings, and in some cases one or more of the steps depicted may occur substantially simultaneously, or additional steps may be involved. Although specific terms are employed herein, they are used in a generic and descriptive sense only and not for purposes of limitation.

## Claims

1. A system for providing short circuit protection comprising:
a dual-output current sensor comprising:
a current sensing element to detect a current;
a current comparison circuity to determine if the detected current exceeds a predetermined threshold current;
a first output channel to output an indication of the detected current from the current sensor;
a drive circuit to produce an amplified output of the current comparison circuity; and
a second output channel to output the amplified output of the current comparison circuity from the current sensor.

2. The system of claim 1, wherein the current sensing element outputs a voltage that is proportional to the detected current; and
wherein the current comparison circuity comprises an analog voltage comparison circuitry that compares the voltage that is proportional to the detected current to a reference voltage that corresponds to the predetermined threshold current.

3. The system of claim 1, wherein the current sensing element outputs a voltage that is proportional to the detected current;
wherein the current comparison circuity comprises an analog to digital controller (ADC) and a controller;
wherein the ADC receives the voltage that is proportional to the detected current and converts the voltage that is proportional to the detected current to a digital value of the detected current; and
wherein the controller receives the digital value of the detected current and compares the digital value of the detected current to the predetermined threshold current.

4. The system of claim 1, further comprising:
a battery management system;
an electric busbar carrying the detected current; and
a normally closed pyrotechnic switch connected inline with the electric busbar;
wherein the first output channel outputs the indication of the detected current to the battery management system; and
wherein the second output channel outputs the amplified output of the current comparison circuity to the pyrotechnic switch to cause the pyrotechnic switch to open and interrupt the detected current on the electric busbar.

5. The system of claim 4, wherein, if the detected current exceeds the predetermined threshold current, the current sensor receives a command from the battery management system to actuate the pyrotechnic switch; and
wherein the second output channel outputs the amplified output of the current comparison circuity to the pyrotechnic switch in response to the current sensor receiving the command from the battery management system to actuate the pyrotechnic switch.

6. A method of providing short circuit protection in an electric vehicle, the method comprising:
connecting a dual-output current sensor to an electric busbar of the electric vehicle;
detecting, by a current sensing element of the current sensor, the current on the electric busbar;
determining, by a current comparison circuitry of the current sensor, if the detected current exceeds a predetermined threshold current;
outputting, by a first output channel of the current sensor to a battery management system of the electric vehicle, an indication of the detected current;
producing, by a drive circuit of the current sensor, an amplified output of the current comparison circuity; and
outputting, by a second output channel of the current sensor to a pyrotechnic switch of the electric vehicle if the detected current exceeds the predetermined threshold current, the amplified output of the current comparison circuity to cause the pyrotechnic switch to open and interrupt the current on the electric busbar.

7. The method of claim 8, wherein the current comparison circuity comprises an analog voltage comparison circuitry; and
wherein the method further comprises:
outputting, by the current sensing element, a voltage that is proportional to the detected current; and
comparing, by the analog voltage comparison circuitry, the voltage that is proportional to the detected current to a reference voltage that corresponds to the predetermined threshold current.

8. The method of claim 8, wherein the current comparison circuity comprises an analog to digital controller (ADC) and a controller; and
wherein the method further comprises:
outputting, by the current sensing element, a voltage that is proportional to the detected current;
receiving, by the ADC, the voltage that is proportional to the detected current;
converting, by the ADC, the voltage that is proportional to the detected current to a digital value of the detected current;
receiving, by the controller, the digital value of the detected current; and
comparing, by the controller, the digital value of the detected current to the predetermined threshold current.

9. The method of claim 6, further comprising:
receiving, by the first output channel of the current sensor if the detected current exceeds the predetermined threshold current, a command from the battery management system to actuate the pyrotechnic switch;
wherein the second output channel outputs the amplified output of the current comparison circuity to the pyrotechnic switch in response to receiving the command from the battery management system to actuate the pyrotechnic switch.
